Europäisches Patentamt

European Patent Office

Office européen des brevets

(19)

(11) Publication number: **0 049 934**
**B1**

(12) **EUROPEAN PATENT SPECIFICATION**

(45) Date of publication of patent specification: **26.09.84**

(21) Application number: **81201130.2**

(22) Date of filing: **12.10.81**

(51) Int. Cl.³: **G 11 B 7/26, G 11 B 7/24, G 03 C 5/00**

(54) Optically readable information disk.

(30) Priority: **15.10.80 NL 8005674**

(43) Date of publication of application:
**21.04.82 Bulletin 82/16**

(45) Publication of the grant of the patent:
**26.09.84 Bulletin 84/39**

(84) Designated Contracting States:
**AT CH DE FR GB IT LI NL SE**

(56) References cited:
**DE-A-2 443 785**
**DE-A-2 810 047**
**NL-A-7 611 395**
**NL-A-7 804 036**

**PHOTOGRAPHIC SCIENCE AND ENGINEERING, vol. 23, no. 5, September/October 1979, Washington, DC, US C.T. CHANG "Physical properties of photopolymers-A biaxial stress-strain test" pages 311-313**

(73) Proprietor: **N.V. Philips' Gloeilampenfabrieken**
**Groenewoudseweg 1**
**NL-5621 BA Eindhoven (NL)**

(72) Inventor: **Van den Broek, Arnoldus Johannes Maria**
c/o **INT. OCTROOIBUREAU B.V. Prof. Holstlaan 6**
**NL-5656 AA Eindhoven (NL)**
Inventor: **Legierse, Petrus Egidius Jacobus**
c/o **INT. OCTROOIBUREAU B.V. Prof. Holstlaan 6**
**NL-5656 AA Eindhoven (NL)**
Inventor: **Ribberink, Henricus Dominicus Maria**
c/o **INT. OCTROOIBUREAU B.V. Prof. Holstlaan 6**
**NL-5656 AA Eindhoven (NL)**

(74) Representative: **Weening, Cornelis et al**
**INTERNATIONAAL OCTROOIBUREAU B.V. Prof. Holstlaan 6**
**NL-5656 AA Eindhoven (NL)**

**Description**

The invention relates to an optically readable information disk which comprises a substrate plate having on at least one side a radiation-cured lacquer layer provided with an information track which has information regions situated alternately at a higher and at a lower level along the track and covered with a reflecting layer.

Such a disk is known from the published Netherlands Patent Application 76 11 395 in the name of Applicants.

Applicants have found that the known information disks have a considerably worse signal-to-noise ratio, abbreviation SNR, than the master plate from which the disks are derived. The master plate is a flat glass plate which is covered on one side with a photoresist layer in which the information track was provided by exposure to laser light followed by photochemical development. First metal copies, the so-called father disks, are made from the master plate electrochemically by electro-deposition, from which father plates second metal copies, also called mother disks, are subsequently made by electrodeposition and herefrom third and subsequent metal copies are manufactured. The last copies of the "family" are termed dies.

The above-mentioned optically readable information disks are manufactured by means of the dies whereby the surface of the die in which the information track is present is provided with a thin layer of a lacquer which is curable by radiation, for example ultraviolet light, the substrate plate is then provided hereon, the assembly is exposed *via* the substrate plate and the resulting disk comprising the substrate plate and the cured lacquer layer connected thereto in which the information track is copied, is finally removed from the die. The cured lacquer layer is provided with a reflecting layer, for example, a vapour-deposited layer of aluminium or silver, on the side of the information track.

The information regions present in the information track have very small dimensions. The longitudinal dimensions vary in accordance with the stored information from approximately 0.3—3 $\mu$m. The difference in height between the regions mutually corresponds to a quarter wavelength (or a multiple thereof) of the laser light with which the disk is read optically and amounts to 1—2 $\mu$m. The disk is read in reflection *via* the substrate plate in which the detection of the information regions is based on phase differences occurring between the forward and the reflected laser light beam.

In the transition from master to die and the subsequent production of the optically readable disk starting with the provision of a light-curable lacquer on the die and up to the vapour deposition of a reflecting layer, all kinds of errors and deviations may occur by which ultimately the quality of the finished plate is determined, which in particular results in a deterioration in the signal-to-noise ratio with respect to the master.

It is the object of the present invention to reduce this loss of signal-to-noise ratio considerably and hence to improve the quality, in particular the quality of the stored information in the optically readable information disk.

According to the invention this object is achieved with an information disk of the type mentioned in the opening paragraph which is characterized in that the lacquer layer has a minimum indentation hardness which corresponds to a maximum penetration depth of 5 $\mu$m of a needle which is placed on the lacquer layer and which comprises a ball-shaped tip manufactured from hard material and having a diameter of 18±1 $\mu$m and presses on the lacquer layer with a weight of 2.5±0.1 gram.

Favourable results are achieved with an information disk the lacquer layer of which has an indentation hardness which corresponds to a penetration depth of 1.5—3.0 $\mu$m.

The desired hardness of the lacquer layer can be obtained by a suitable choice of the ingredients of a radiation-curable lacquer which, after exposure, for example, to ultraviolet light, provides the cured lacquer layer. In this case it is understood that a worker skilled in the art will make a choice from the commercially available lacquers or lacquer components so that the lacquer per unit by volume comprises a large number of cross-linkable groups and so that, after curing a large number of cross-links is formed. Preferably the starting material is a curable lacquer which comprises radiation curable monomers having two or more cross-linkable groups which hereinafter also are termed functional groups, per molecule. Herewith it is achieved that upon curing in addition to linear polymerization, many cross-links are realized which leads to a network structure.

Particularly suitable are radiation-curable lacquers comprising at least 50% by weight of a diacrylate, a triacrylate or a mixture thereof.

Di- and triacrylates comprise respectively two and three functional groups, in this case ethene groups, per molecule. Examples of such acrylates are alkanedioldiacrylates, such as 1,3-propane-diol-diacrylate, 1,4-butanedioldiacrylate and 1,6-hexanedioldiacrylate; alkeneglycoldiacrylates, such as diethyleneglycoldiacrylate, triethyleneglycoldiacrylate and tripropyleneglycoldiacrylate, as well as trimethylolpropanetriacrylate, pentaerythritoltriacrylate and pentaerythritolpropylethertriacrylate.

The lacquer also comprises a conventional photosensitive catalyst, such as, an aromatic carbonyl compound for example, benzoinisobutylether or a ketal, for example, benzoinisobutylether or a ketal, for example, benzildimethylketal, in a quantity from approximately 1 to 5% by weight.

In a preferred embodiment the diacrylate, triacrylate or a mixture thereof used in the radiation-curable lacquer has an average molecular weight from 200 to 350. The very good results obtained by

**0 049 934**

using said lacquer are quite surprising. It may be expected that the comparatively low-molecular products will show a comparatively high shrinkage upon curing so that the results are influenced just negatively. The opposite is the case which, in Applicants opinion, is caused by the comparatively low viscosity of the lacquer (smaller than 30 cP) so that very thin layers can be realized in a thickness smaller than 50 $\mu$m, for example 20—35 $\mu$m. As a result of this the absolute shrinkage is small. It is further believed that due to the low viscosity the mobility of the unpolymerized molecules during the curing process is still sufficient to fill up the space between the lacquer layer and the information track present in the die which arises from shrinkage. The thickness of the cured lacquer layer then becomes slightly smaller but this has no influence on the signal-to-noise ratio.

The low viscosity furthermore has for the result that the radiation-curable lacquer can more easily be distributed over the die surface, while the possibility of air bubble inclusion is smaller.

In a further preferred embodiment the radiation-curable lacquer comprises in addition to the di- and/or trifunctional compound, also a monofunctional compound.

Examples of monofunctional compounds are monoacrylates which per molecule comprise one ethene group —c=c—, for example, alkylacrylates, for example ethylacrylate, butylate, hexylacrylate and ethylhexylacrylate, alkoxyalkylacrylates, for example, ethoxyethylacrylate, phenoxyalkylacrylates, for example, phenoxyethylacrylate, as well as phenylacrylate.

The addition of monofunctional compounds stimulates the adhesion of the cured lacquer layer to the substrate plate particularly if the plate is manufactured from a synthetic resin, for example, polyvinylchloride, polymethylmethacrylate or polycarbonate. Furthermore, the viscosity of the lacquer can be reduced by the addition of the monofunctional compound.

A very favourable monofunctional compound is an alkylenepyrrolidone in particular vinylpyrrolidone. This substance also improves the adhesion of the cured lacquer layer, reduces the viscosity of the lacquer and has the further advantage that the hardness of the resulting cured lacquer layer is less influenced than when the above-mentioned monoacrylates are used, while furthermore in contrast with monoacrylates the substance does not reduce the curing rate but on the contrary increases same.

The invention will now be described in greater detail by means of the drawing and the following example, in which

Figure 1 is a cross-sectional view of a microidentation hardness measuring instrument used in determining the hardness of the lacquer layer present in the information disk according to the invention, and

Figure 2 is a cross-sectional view of an information disk according to the invention.

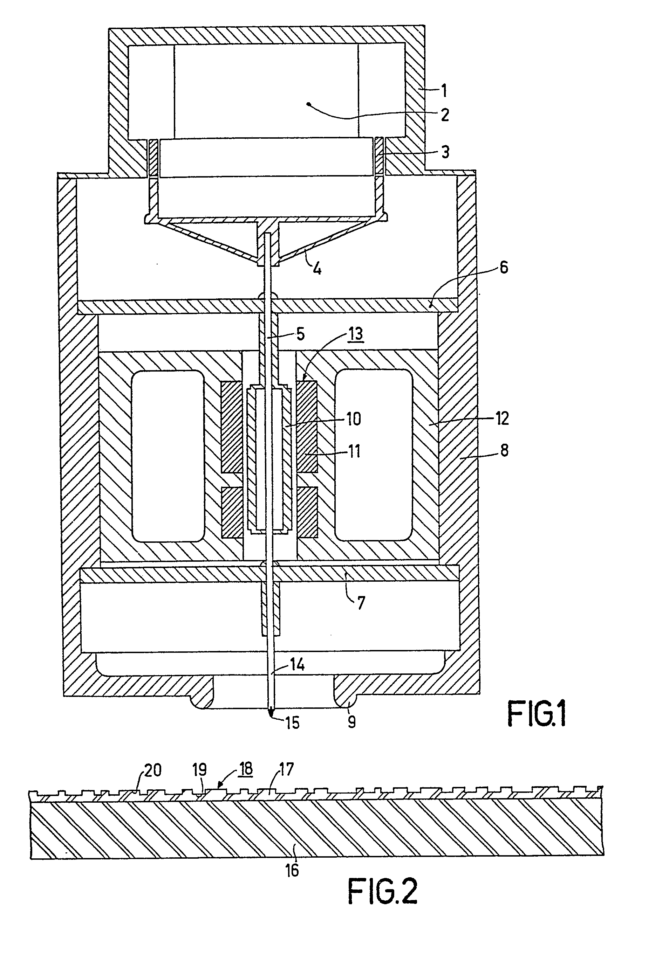

Reference numeral 1 in Figure 1 denotes an envelope for a permanent magnet 2 which may be manufactured, for example, from ferroxdur. An electric coil 3 which is connected to the needle system 5 *via* holder 4 is provided around magnet 2. The assembly of coil 3, holder 4 and needle system 5 has a weight of 3 g and is suspended in two flat spiral supporting springs 6 and 7, which are extremely flexible in the vertical direction and have a great rigidity in the horizontal direction. The spiral supporting springs 6, 7 are accommodated in a housing 8 which is connected to the envelope 1. Housing 8 has a reference ring 9 which is brought in contact with the surface of the information disk to be measured (not shown in Figure 1). The needle system 5 has a magnetic body 10 of ferroxdur which cooperates with coils 11 accommodated in coil holder 12. Magnet core 10 and coils 11 together constitute a displacement pick-up 13. Needle system 5 furthermore comprises at its end remote from holder 4 a needle 15 provided in needle holder 14. Needle 15 is manufactured from sapphire and has a ball-shaped tip having a diameter of 18 $\mu$m.

The operation of the micro-identation hardness measuring instrument as shown in Figure 1 is as follows. By passing current *via* the coil 3 the needle system 5 is brought in a retracted position in which the needle 15 is at a certain distance above the surface determined by reference ring 9. The hardness mesauring instrument is then brought perpendicular to the surface of an information disk to be measured, reference ring 9 being in contact with the surface of the disk. The current strength through coil 3 is slowly reduced in which the needle system 5 is lowered as a result of its own weight, that is to say moves in the direction of the surface of the disk. As soon as the needle 15 contacts the surface of the disk a small reduction of the current strength through coil 3 will not result in any further displacement of the needle. In this manner the needle can be brought in contact with the surface of the disk while completely balanced, that is to say without there being any downward force. The current strength through coil 3 is now adjusted so that a downward force of 2.5 g is exerted on the needle 15. Since the needle system 5 has an own weight of 3 g this means thus that by cooperation of coil 3 and magnet 2 an upward force of 0.5 g is exerted on the needle system 5 so that the resultant of the forces yields the above-mentioned downward force of 2.5 g. The depth of penetration of needle 15 caused by said force is measured in the usual manner by means of the displacement pick-up 13 known *per se*. It is to be noted that the indentation hardness of the optical disk can also be measured, besides by the instrument as shown in Figure 1, also by means of the commercially available micro-identation measuring instruments, for example, the indentation measuring instrument which is available as Wallace, type H7a, manufactured by H. W. Wallace & Co., Ltd., Croydon, England.

Reference numeral 16 in Figure 2 denotes a 1.2 mm thick substrate plate of synthetic resin, for

3

example polyvinyl-chloride or polymethyl-methacrylate, which on one side has a hard radiation cured lacquer layer 17 comprising an information track 18. Track 18 comprises information regions which are situated alternately at a lower level 19 and a higher level 20 and collectively give the track a crenellated profile. The length dimensions of the information regions vary in accordance with the stored information from approximately 0.3 to 3 $\mu$m. The difference in height between the regions is 1.15 $\mu$m. Layer 17 is covered by a vapour-deposited reflection layer not shown, in particular a layer of vapour-deposited Ag or Al.

The micro-indentation hardness of lacquer layer 17 was determined for various lacquer compositions. For this purpose, the depth of penetration of the needle was mesured by means of the instrument shown in Figure 1. Furthermore, the loss of signal-to-noise ratio of the resulting information disk which is covered with a reflection layer of silver or aluminium was determined in comparison with the signal-to-noise ratio of the master plate. The resulting data are recorded in the table below in which in column 1 the sequential number of the lacquer is recorded, column 2 gives the reflection layer used, column 3 the measured depth of penetration in the cured lacquer layer and column 4 gives the loss of signal-to-noise ratio with respect to the master. The composition of the lacquers is recorded after the table. It is to be noted that the information disk in which the lacquer having sequential number 5 has been used is known from the above mentioned Netherlands Patent Application No. 76 11 395 so that the data which relate to lacquer number 5 are recorded in the table as comparison material.

Table

| Lacquer sequential No. | Reflection layer | Depth of penetration | Loss of signal-to-noise ratio |
|---|---|---|---|
| 1 | Ag | 2.1 | 0.8 |
| 1 | Al | 2.1 | 1.2 |
| 2 | Ag | 3.5 | 0 |
| 2 | Al | 3.5 | 1.3 |
| 3 | Al | 2.2 | 0.5 |
| 4 | Ag | 2.6 | 1.2 |
| 4 | Al | 2.6 | 1.5 |
| 5 | Ag | 9.0 | 8.2 |
| 5 | Al | 9.0 | 6.0 |

Composition of the lacquers:
Lacquer no. 1:
  64 wt % pentaerythritolpropylethertriacrylate
  16 wt % N-vinylpyrrolidone
  16 wt % hexanedioldiacrylate
  4 wt % benzildimethylketal

Lacquer no. 2:
  78 wt % tripropyleneglycoldiacrylate
  20 wt % N-vinylpyrrolidone
  2 wt % benzildimethylketal

Lacquer no. 3:
  58 wt % tripropyleneglycoldiacrylate
  28 wt % N-vinylpyrrolidone
  10 wt % trimethylolpropanetriacrylate
  4 wt % benzildimethylketal

Lacquer no. 4:
  78 wt % ethoxylated trimethylolpropanetriacrylate (koskydal K-5-2445)
  20 wt % N-vinylpyrrolidone
  2 wt % benzoinisobutylether

4

Lacquer no. 5:
    59 wt % 2-ethylhexylacrylate
    19.5 wt % butanedioldiacrylate
    19.5 wt % trimethylolpropanetriacrylate
    2 wt % benzoinisobutylether

## Claims

1. An optically readable information disk which comprises a substrate plate having on at least one side a radiation-cured lacquer layer provided with an information track which has information regions situated alternately at a higher and a lower level along the track and covered with a reflective layer, characterized in that the cured lacquer layer has a minimum indentation hardness which corresponds to a maximum depth of penetration of 5 $\mu$m of a needle which is placed on the lacquer layer and which has a ball-shaped tip manufactured from a hard material and having a diameter of 18$\pm$1 $\mu$m and presses on the layer with a weight of 2.5$\pm$0.1 g.

2. An information disk as claimed in Claim 1, characterized in that the lacquer layer has an indentation hardness which corresponds to a depth of penetration of 1.5—3.0 $\mu$m.

3. An information disk as claimed in Claim 1 or 2, characterized in that the radiation curable lacquer used for the manufacture of the cured lacquer layer comprises at least 50% by weight of a diacrylate, triacrylate or a mixture thereof.

4. An information disk as claimed in Claim 3, characterized in that the diacrylate, triacrylate or the mixture thereof has an average molecular weight of 200—350.

5. An information disk as claimed in Claim 3 or 4, characterized in that the lacquer also comprises a monofunctional compound.

6. An information disk as claimed in Claim 5, characterized in that the monofunctional compound is N-vinylpyrrolidone.

## Revendications

1. Un disque d'information lisible par voie optique, qui comporte une plaque de substrat, dont au moins une face est munie d'une couche de vernis durcie par rayonnement présentant une piste d'information munie de domaines d'information situés alternativement à un niveau plus élevé et à un niveau plus bas le long de la piste et recouverte d'une couche réflectirce, caractérisé en ce que la couche de vernis durcie présente une dureté d'impression minimale correspondant à une profondeur de pénétration maximale de 5 $\mu$m d'une aiguille qui présente une extrémité sphérique réalisée en matériau dur et d'un diamètre de 18$\pm$1 $\mu$m, et qui, placée sur la couche de vernis, exerce sur cette dernière une pression d'un poids de 2,5$\pm$0,1 g.

2. Disque d'information selon la revendication 1, caractérisé en ce que la couche de vernis présente une résistance à la pénétration qui correspond à une profondeur de pénétration de 1,5 à 3,0 $\mu$m.

3. Disque d'information selon la revendication 1 ou 2, caractérisé en ce que le vernis durcissant par rayonnement utilisé pour la réalisation de la couche de vernis durcie, contient, en poids, 50% d'un diacrylate, triacrylate ou l'un de leurs mélanges.

4. Disque d'information selon la revendication 3, caractérisé en ce que le diacrylate, le triacrylate ou l'un de leurs mélanges présente un poids moléculaire moyen de 200 à 350.

5. Disque d'information selon la revendication 3 ou 4, caractérisé en ce que le vernis contient également un composé monofonctionnel.

6. Disque d'information selon la revendication 5, caractérisé en ce que le composé monofonctionnel est la N-vinylpyrrolidone.

## Patentansprüche

1. Optisch auslesbare Informationsscheibe, die eine Substratplatte enthält, die auf mindestens einer Seite mit einer mit Strahlung gehärteten Lackschicht versehen ist, in der eine Informationsspur mit abwechselnd auf höherem und auf niedrigerem Niveau liegenden Informationsgebieten angebracht ist, und die mit einer reflektierenden Schicht abgedeckt ist, dadurch gekennzeichnet, dass die Lackschicht eine minimale Eindruckhärte aufweist, die einer maximalen Eindringtiefe von 5 $\mu$m einer auf die Lackschicht gesetzten Nadel entspricht, die mit einer aus einem harten Material bestehenden kugelförmigen Spitze mit einem Durchmesser von 18$\pm$1 $\mu$m versehen ist und mit einem Gewicht von 2,5$\pm$0,1 g auf die Lackschicht drückt.

2. Informationsscheibe nach Anspruch 3, dadurch gekennzeichnet, dass die Lackschicht eine Eindruckhärte aufweist, die einer Eindringtiefe von 1,5 bis 3,0 $\mu$m entspricht.

3. Informationsscheibe nach Anspruch 1 oder 2, dadurch gekennzeichnet, dass der durch Strahlung härtbare Lack zur Anwendung für die Herstellung der gehärteten Lackschicht mindestens 50 Gew.% eines Diakrylats, eines Triakrylats oder eines Gemisches derselben enthält.

## 0 049 934

4. Informationsscheibe nach Anspruch 3, dadurch gekennzeichnet, dass das Diakrylat, das Triakrylat oder das Gemisch derselben ein mittleres Molekulargewicht von 200 bis 350 aufweist.

5. Informationsscheibe nach Anspruch 3 oder 4, dadurch gekennzeichnet, dass der Lack ausserdem eine monofunktionelle Verbindung enthält.

6. Informationsscheibe nach Anspruch 5, dadurch gekennzeichnet, dass die monofunktionelle Verbindung N-Vinylpyrrolidon ist.

FIG.1

FIG.2